# EUROPÄISCHE PATENTANMELDUNG

(11) **EP 2 079 117 A2**
(43) Veröffentlichungstag der Anmeldung: **15.07.2009**
(21) Anmeldenummer: 09100014.1
(22) Anmeldetag: 07.01.2009
(51) Int. Cl.: H01L 41/083

(54) **Piezoaktormodul mit mehreren Piezoaktoren und ein Verfahren zu dessen Herstellung**

(30) Priorität: 14.01.2008 DE 102008004227
(71) Anmelder: ROBERT BOSCH GMBH, 70442 Stuttgart (DE)
(72) Erfinder: Dirscherl, Florian, 96049, Bamberg (DE); Pohl, Gerd, 02906, Waldhufen Thiemendorf (DE)

(57) **Zusammenfassung**

Es wird ein Piezoaktormodul (1) mit mindestens zwei in der mechanischen Wirkungsrichtung hintereinander geschalteten Piezoaktoren (2,3) vorgeschlagen, die jeweils aus in der mechanischen Wirkungsrichtung hintereinander geschalteten Piezoelementen mit Innenelektroden (4,5) bestehen, und über eine Klebeverbindung (6) zwischen den Piezoaktoren (2,3) miteinander verbunden sind, wobei die Klebeverbindung (6) kraftschlüssig zwischen den gegenüberliegenden Grenzschichten der Piezoaktoren (2,3) und dem Aktorkopf (9) und/oder dem Aktorfuß(10) im gesamten Querschnitt der Piezoaktoren (2,3) angebracht ist und vorzugsweise die Klebeverbindung (6) aus einem Klebstoff (7) mit festen Partikeln (8), beispielsweise mit keramischen Partikeln (8), als Füllstoff gebildet ist.

## Beschreibung

### Stand der Technik

Die Erfindung betrifft ein Piezoaktormodul mit einer Anordnung von mehreren mechanisch in Reihe geschalteten Piezoaktoren, vorzugsweise zur Verwendung in einem Piezoinjektor, nach den gattungsgemäßen Merkmalen des Anspruchs 1 und ein Verfahren zur Herstellung eines Piezoaktormoduls mit den Merkmalen des Anspruchs 6.

Ein solcher Piezoinjektor besteht im Wesentlichen aus einem Haltekörper und dem in dem Haltekörper angeordneten Piezoaktormodul, das die zwischen einem Kopf- und Fußteil und Anbindebauteilen angeordneten Piezoaktoren aufweist, die jeweils aus mehreren übereinandergestapelten Piezoelementen aufgebaut sind.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist. Jede Piezolage eines Piezoelements ist auch hier zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Da der maximale Hub eines solchen Piezoaktormoduls proportional zu seiner Länge ist, sind für Piezoaktormodule mit hohem Hubbedarf entsprechend lange Piezoaktoren nötig. Neben dem Einsatz langer Einzelaktoren lässt sich der benötigte Hub auch durch ein Aufeinanderschichten kurzer Piezoaktoren realisieren. Beispielsweise dadurch, dass mindestens zwei Piezoaktoren stirnseitig zu einer Aktorreihe aneinandergefügt werden. Es ist dabei hinlänglich bekannt, dass diese Reihe aus mehreren einzelnen Piezoaktoren beispielsweise mittels einer äußeren Klebeverbindung zusammengeklebt ist und gekapselt in einer metallischen Hülse das Herzstück des zuvor erläuterten Piezoinjektors bildet. Die elektrische Verbindung der einzelnen Piezoaktoren bzw. deren Außenelektroden zur Kontaktierung der Innenelektroden kann dabei in an sich bekannter Weise beispielsweise mittels einer elektrisch leitenden Brücke zwischen den Außenelektroden gleicher Polarität der einzelnen Piezoaktoren realisiert werden.

Aus der DE 10 2004 030 868 A1 ist dazu ebenfalls bekannt, dass sich diese Einzelaktoren durch Kleben verbinden lassen. Um einen Hubverlust aufgrund der Klebschicht zu vermeiden, wird hierbei der Klebstoff als radiales Ringelement zwischen den Einzelaktoren in einer äußeren Nut angeordnet.

### Offenbarung der Erfindung

Die Erfindung geht von einem Piezoaktormodul mit mindestens zwei in der mechanischen Wirkungsrichtung zur Verbesserung der Hubleistung hintereinander geschalteten Piezoaktoren aus. Um eine einfache und kostengünstige Klebeverbindung zwischen den Piezoaktoren herzustellen, ist in vorteilhafter Weise die Klebeverbindung kraftschlüssig zwischen den gegenüberliegenden Grenzschichten der Piezoaktoren im gesamten Querschnitt der Piezoaktoren aufgebracht. Das Piezoaktormodul kann vorzugsweise Bestandteil eines Piezoinjektors mit einer Nadelansteuerung für ein Einspritzsystem für Kraftstoff bei einem Verbrennungsmotor sein.

Aufgrund der Erfindung kann die Klebeverbindung als Schicht zwischen den Grenzschichten der Piezoelemente derart eingebracht werden, dass die Druckbelastung im Betrieb des Piezoaktormoduls zu keinem Hubverlust führt. Da die Klebeschicht im Kraftfluss zwischen den Schichten eingebracht werden kann, vereinfacht sich auch die Geometrie der Piezoelemente in den Grenzschichten, da die im Stand der Technik beispielsweise notwendigen Nuten in den Piezoaktoren zur Einbringung der Klebeverbindung nicht notwendig sind und somit radialer Bauraum eingespart wird. Auch der Klebstoffauftrag vereinfacht sich dadurch und der Schichtaufbau in der Wirkrichtung der Piezoaktoren wird homogenisiert.

Gemäß einer besonders vorteilhaften Ausführungsform des erfindungsgemäßen Piezoaktormoduls besteht die Klebeverbindung aus einem Klebstoff mit keramischen Partikeln, wobei der Füllgrad der keramischen Partikel in Abhängigkeit von der Druckbelastung der jeweils aneinanderliegenden Piezoaktoren in deren Wirkrichtung und/oder der Härte des Materials der aneinanderliegenden Piezoaktoren gewählt ist. Ist der Füllgrad zu gering, wird die Druckbelastung auf zu wenig Stützstellen verteilt, sodass die resultierende lokale Druckbelastung der angrenzenden Piezoelemente der Piezoaktoren zu groß wird und der Füllstoff in die Piezoelemente eindringen kann, sodass ein Füllgrad von größer 30% anzustreben ist.

Der zum Einsatz kommende Klebstoff für die Klebeverbindung wird somit vorzugsweise derart mit keramischen Partikeln gefüllt, dass über die die Füllstoffgröße die Klebschichtdicke definiert wird und diese daher hinsichtlich der davon abhängigen Verbindungseigenschaften ausgewählt wird. Die Verteilung der Partikelgröße ist vorzugsweise sehr eng zu wählen, um am insgesamt verklebten Piezoaktormodul eine minimale Gesamtlängenstreuung zu erreichen.

Bei einem vorteilhaften Verfahren zur Herstellung eines zuvor beschriebenen Piezoaktormoduls wir in einem ersten Verfahrensschritt das Material der Klebeverbindung auf eine Grenzschicht eines der Piezoaktoren als Fügepartner aufgetragen, in einem zweiten Verfahrensschritt wird der andere Piezoaktor als Fügepartner aufgebracht und in einem dritten Verfahrensschritt wird eine Aushärtung der Klebeverbindung unter Aufbringung einer mechanischen Vorspannung auf die Fügepartner in der Wirkrichtung der Piezoaktoren durchgeführt.

Ziel dieses vorgeschlagenen Verfahrens ist es, in Abhängigkeit von dem Material des Klebstoffs und der Prozessierung auch wahrend des Aushärtens mit der Vorspannung die Klebeverbindung soweit zu komprimieren, dass die Piezoaktoren als Fügepartner auf den Füllstoffen der Klebeverbindung sicher aufsetzen. Erst durch diese Prozessierung ist somit sichergestellt, dass die Drucksteifigkeit im Bereich der Klebeverbindung ausreichend groß ist und im Betrieb des Piezoaktormoduls kein Hubverlust des Piezoaktormoduls entsteht.

### Kurze Beschreibung der Zeichnungen

Ein Ausführungsbeispiel des erfindungsgemäßen Piezoaktormoduls wird anhand der Zeichnung erläutert. Es zeigt:

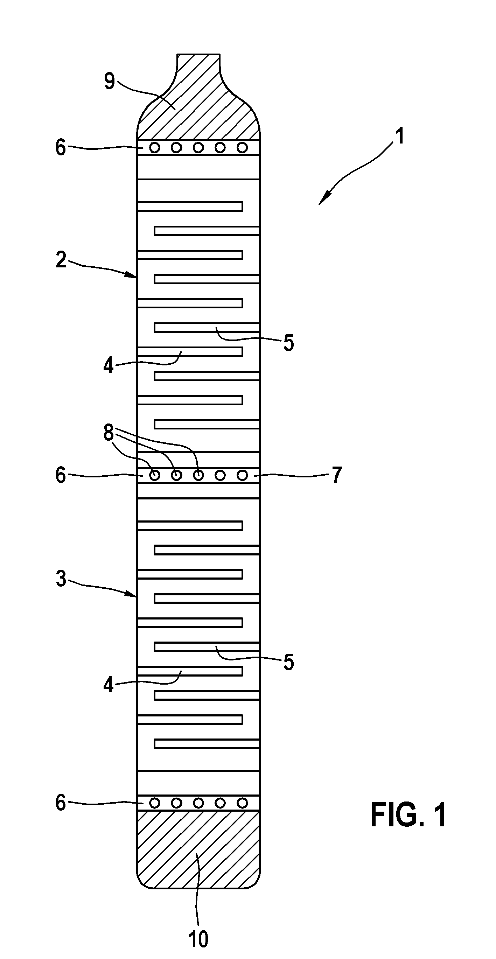

Figur 1 eine Ansicht auf zwei aneinandergereihte Piezoaktoren für ein Piezoaktormodul mit einer Klebeverbindung aus einem mit Füllstoff versehenen Klebstoff zwischen den Piezoaktoren bzw. dem Aktorkopf und/oder dem Aktorfuß.

### Ausführungsformen der Erfindung

Im Folgenden wird ein Piezoaktormodul 1 erläutert, das beispielsweise für einen Piezoinjektor zur Nadelhubsteuerung in einem Einspritzsystem für Kraftstoff bei einem Verbrennungsmotor eingesetzt werden kann, wie es eingangs anhand des Standes der Technik beschrieben ist. Hierzu sind nach Figur 1 ein Piezoaktor 2 und ein Piezoaktor 3 zur Bildung des Piezoaktormoduls 1 in der mechanischen Wirkrichtung hintereinander geschaltet, sodass mit den in der Beschreibungseinleitung beschriebenen Piezoelementen in den Piezoaktoren 2 und 3 ein mechanischer Hub in der Längserstreckung des Piezoaktormoduls 1 bewirkt werden kann.

Die Piezoelemente in den Piezoaktoren 2 und 3 werden durch Innenelektroden der einen Polarität und Innenelektroden der jeweils anderen Polarität und den dazwischenliegenden Piezolagen gebildet, wobei in der Figur 1 nur beispielhaft jeweils nur zwei Innenelektroden 4 und 5 mit Bezugszeichen versehen sind. Die Kontaktierung der Innenelektroden 4 und 5 über Außenelektroden ist hier nicht dargestellt, sie erfolgt in der gleichen Weise wie beim Stand der Technik.

Es ist beim in der Figur 1 gezeigten Ausführungsbeispiel eine Klebeverbindung 6 zwischen den Piezoaktoren 2 und 3 und zu einem Aktorkopf 9 und zu einem Aktorfuß 10 vorhanden, die kraftschlüssig zwischen den gegenüberliegenden Grenzschichten der Piezoaktoren 2 und 3 im gesamten Querschnitt der Piezoaktoren 2 und 3 liegt.

Die Klebeverbindung 6 besteht aus einem Klebstoff 7 mit einem Füllstoff, der hier aus keramischen Partikeln 8 besteht, die in der Figur 1 schematisch angedeutet sind. Der Füllgrad der keramischen Partikel 8 ist dabei so gewählt, dass die Klebeverbindung 8 der Druckbelastung im Betrieb des Piezoaktormoduls 1 optimal standhält. Ein optimaler Füllgrad von größer 30% bietet hier die meisten Vorteile, wobei die Verteilung der Partikel 8 sehr eng zu wählen ist, um am insgesamt verklebten Piezoaktormodul 1 eine minimale Gesamtlängenstreuung zu erreichen.

Zur Herstellung des Piezoaktormoduls 1 wird in einem ersten Verfahrensschritt das Material 7 und 8 der Klebeverbindung 6 auf eine Grenzschicht eines der Piezoaktoren 2 oder 3 aufgetragen, in einem zweiten Verfahrensschritt wird der andere Piezoaktor 2 oder 3 bzw. der Aktorkopf 9 und/oder der Aktorkopf 10 als Fügepartner aufgebracht und in einem dritten Verfahrensschritt wird eine Aushärtung der Klebeverbindung 6 unter Aufbringung einer hier nicht gezeigten mechanischen Vorspannung auf die Fügepartner in der Wirkrichtung der Piezoaktoren 2 und 3 durchgeführt.

## Patentansprüche

1. Piezoaktormodul mit mindestens zwei in der mechanischen Wirkungsrichtung hintereinander geschalteten Piezoaktoren (2,3), die jeweils aus in der mechanischen Wirkungsrichtung hintereinander geschalteten Piezoelementen mit Innenelektroden (4,5) bestehen, und mit einer Klebeverbindung zwischen den Piezoaktoren (2,3), **dadurch gekennzeichnet, dass** die Klebeverbindung (6) kraftschlüssig zwischen den gegenüberliegenden Grenzschichten der Piezoaktoren (2,3) im gesamten Querschnitt der Piezoaktoren (2,3) angebracht ist.

2. Piezoaktormodul nach Anspruch 1, **dadurch gekennzeichnet, dass** die Klebeverbindung (6) kraftschlüssig auch zwischen der jeweiligen Grenzschicht der Piezoaktoren (2,3) und dem Aktorkopf (9) und/oder dem Aktorfuß (10) im gesamten Querschnitt der Piezoaktoren (2,3) angebracht ist.

3. Piezoaktormodul nach Anspruch 1 oder 2, **dadurch gekennzeichnet, dass** die Klebeverbindung aus einem Klebstoff (7) mit festen Partikeln (8) als Füllstoff gebildet ist.

4. Piezoaktormodul nach Anspruch 3, **dadurch gekennzeichnet, dass** der Füllstoff aus keramischen Partikeln (8) besteht.

5. Piezoaktormodul nach Anspruch 3 oder 4, **dadurch gekennzeichnet, dass** der Füllgrad des Füllstoffs mit den Partikeln (8) in Abhängigkeit von der Druckbelastung der jeweils aneinanderliegenden Piezoaktoren (2,3) in deren Wirkrichtung und/oder der Härte des Materials der aneinanderliegenden Piezoelemente gewählt ist.

6. Piezoaktormodul nach Anspruch 5, **dadurch gekennzeichnet, dass** der Füllgrad 30% vom Volumen des Klebstoffs (7) der Klebeverbindung (6) beträgt.

7. Verfahren zur Herstellung eines Piezoaktormoduls nach einem der vorhergehenden Ansprüche, **dadurch gekennzeichnet, dass** in einem ersten Verfahrensschritt das Material der Klebeverbindung (6) auf eine Grenzschicht eines der Piezoaktoren (2,3) als Fügepartner aufgetragen wird, in einem zweiten Verfahrensschritt der jeweils andere Piezoaktor (2,3) als Fügepartner aufgebracht wird und in einem dritten Verfahrensschritt eine Aushärtung der Klebeverbindung (6) unter Aufbringung einer mechanischen Vorspannung auf die Fügepartner in der Wirkrichtung der Piezoaktoren (2,3) durchgeführt wird.

8. Piezoaktormodul nach einem der vorhergehenden Ansprüche, **dadurch gekennzeichnet, dass** das Piezoaktormodul (1) Bestandteil eines Piezoinjektors mit einer Nadelansteuerung für ein Einspritzsystem für Kraftstoff bei einem Verbrennungsmotor ist.
